# EUROPEAN PATENT APPLICATION

(11) **EP 4 213 599 A1**
(43) Date of publication of application: **19.07.2023**
(21) Application number: 22211741.8
(22) Date of filing: 06.12.2022
(51) Int. Cl.: H05K 3/06

(54) **METHOD OF MANUFACTURING A COMPONENT CARRIER METAL TRACE, AND COMPONENT CARRIER**

(30) Priority: 06.12.2021 CN 202111478371
(71) Applicant: AT & S Austria Technologie & Systemtechnik Aktiengesellschaft, 8700 Leoben-Hinterberg (AT)
(72) Inventor: Lee, Minwoo, Chongqing (CN); Baftiri, Artan, Chongqing (CN)
(74) Representative: Dilg, Haeusler, Schindelmann Patentanwaltsgesellschaft mbH

(57) **Abstract**

It is described a method of manufacturing a component carrier (100), wherein the method comprises:
i) providing a metal layer (110), in particular a copper layer;
ii) forming a film (120) on the metal layer (110);
iii) patterning the film (120) in order to expose a part (111) of the metal layer (110);
iv) carrying out a first etch, thereby thinning the film (120) and removing a further part (112) of the exposed metal layer (110); and thereafter
v) carrying out a second etch, thereby forming at least one metal trace (130) that is spatially separated from the metal layer (110).

## Description

### Technical Field

The invention relates to a method of manufacturing a component carrier, in particular a component carrier metal trace, more in particular using etching. Further, the invention relates to a component carrier manufactured with the method.

Thus, the invention may relate to the technical field of manufacturing a component carrier such as a printed circuit board or an IC substrate.

### Technical Background

In the context of growing product functionalities of component carriers equipped with one or more electronic components and increasing miniaturization of such electronic components as well as a rising number of electronic components to be mounted on the component carriers such as printed circuit boards, increasingly more powerful array-like components or packages having several electronic components are being employed, which have a plurality of contacts or connections, with ever smaller spacing between these contacts. Removal of heat generated by such electronic components and the component carrier itself during operation becomes an increasing issue. Also an efficient protection against electromagnetic interference (EMI) becomes an increasing issue. At the same time, component carriers shall be mechanically robust and electrically reliable so as to be operable even under harsh conditions.

In particular, accurately etching a component carrier in order to provide an electrically conductive trace with a specific quality may be considered a challenge.

According to an example, the process of manufacturing an electrically conductive trace may be described as follows: a photoresist protects copper paths which shall not be etched away, while copper areas which shall be etched away are not covered with the photoresist. At first, for this purpose, the entire copper layer is covered with the photoresist. Then, through a mask, the photoresist is patterned by UV-light. The mask passes UV-light only at positions, where the photoresist shall remain (i.e. where the desired conductor traces shall be provided). During developing, the resist (and the polymer, respectively) is cross-linking at the positions which have been exposed to UV-light. After developing, the photoresist which was not exposed (and not developed, respectively) can be easily washed away. Subsequently, the corresponding component carrier preform is etched. The photoresist protects the conductor traces, while the copper, which is not covered with photoresist, is etched/removed. When the etching process is finished, the photoresist is removed and peeled off, respectively (the resist is cross-linked and solid), and the electrically conductive trace remains.

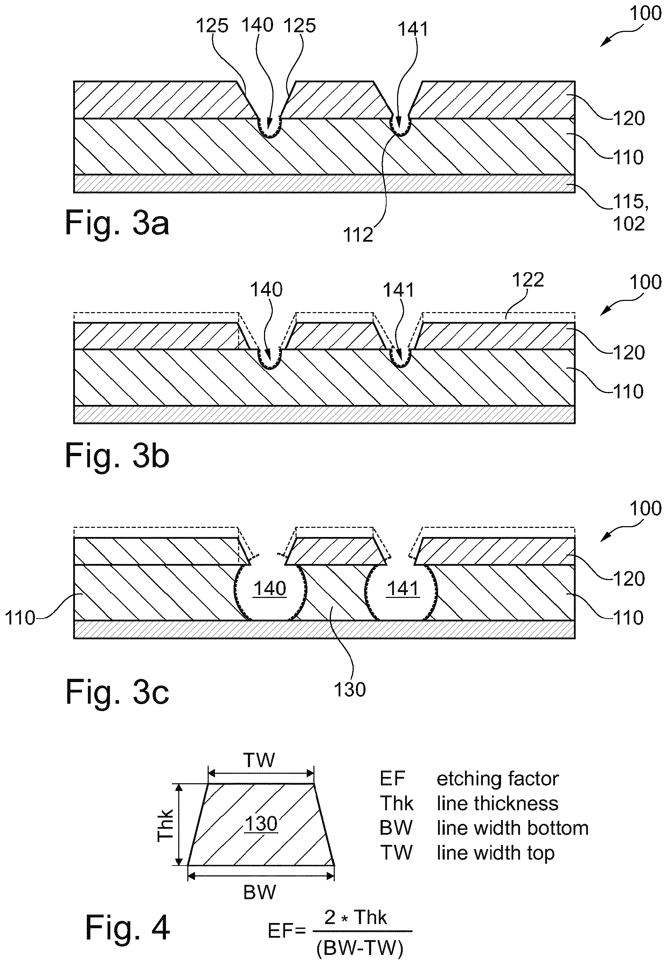

However, it may be considered a challenge to reach a specific line-space ratio (miniaturization) and/or an accurate etching factor (see Figure 4 for definition), in particular when etching a thick copper layer.

### Summary of the Invention

There may be a need to provide a component carrier metal trace in an accurate and reliable manner.

A manufacturing method and a component carrier according to the independent claims are provided.

According to an aspect of the invention, there is described a method of manufacturing a component carrier, wherein the method comprises:
i) providing a metal layer (in particular a copper layer, more in particular a thick copper layer),
ii) providing a film (e.g. a dry film or wet film, in particular a dry photoresist) on the metal layer,
iii) patterning the film (e.g. using photo-imaging) in order to expose an area (part) of the metal layer (in particular to expose a part of the upper main surface below the film),
iv) carrying out (performing) a first etch, thereby removing a (further) part (in particular from the upper main surface, the further part of the metal layer may include the part of the metal layer) of the exposed metal layer and maintaining a thickness of the film (120) (in particular thinning the film), and thereafter
v) carrying out (performing) a second etch, thereby forming at least one metal trace that is spatially separated from the (rest of the) metal layer (in particular separated by etched cavities that separate the metal trace from the rest of the metal layer) (in other words: carrying out a second etch on the same area as the first etch, wherein said second etch is configured to remove a second part of the exposed metal layer (resulting from the first etch), thereby dividing the metal layer along its thickness in said etched area).

According to a further aspect of the invention, there is described a component carrier (in particular manufactured by the method described above) which comprises a stack having at least one electrically conductive layer structure and at least one electrically insulating layer structure. Hereby, the at least one electrically conductive layer structure comprises a metal trace and a further metal trace arranged side by side. The component carrier comprises further at least one of the following features:
i) each of the metal trace and the further metal trace has a bottom-sided line width (L1) of 40 µm or less;
ii) the metal trace and the further metal trace are spaced by a bottom-sided spacing (S) of 45 µm or less;
iii) each of the metal trace and the further metal trace has a top-sided line width (L2) of at least 80% of its respective bottom-sided line width (L1);
iv) each of the metal trace and the further metal trace has a vertical thickness (z) of 30 µm or more.

In the context of the present document, the term "component carrier" may particularly denote any support structure which is capable of accommodating one or more components thereon and/or therein for providing mechanical support and/or electrical connectivity. In other words, a component carrier may be configured as a mechanical and/or electronic carrier for components. In particular, a component carrier may be one of a printed circuit board, an organic interposer, a metal core substrate, an inorganic substrate and an IC (integrated circuit) substrate. A component carrier may also be a hybrid board combining different ones of the above mentioned types of component carriers. The term "component carrier preform" may refer to a semi-finished product that will result, after several process steps, in a final component carrier. A preform may e.g. be a panel that comprises a plurality of (semi-finished) component carriers that will be separated in a further manufacturing step.

In this document, the term "etch (process)" may in particular denote a process of the component carrier, in particular circuit board and/or substrate, manufacture, which comprises an etching of metal, in particular copper, to thereby provide a desired metallic (electrically conductive) structure (such as a metal trace). Depending on the etch, metal material and/or film material may be removed. An etch may be one of a wet etch, a dry etch, a plasma etch, in particular a descum etch. In a particular embodiment, the first etch step may be substituted by a drilling.

In this document, the term "metal trace" may refer to any structure of metal (in particular copper) that can be used as an electric conductor. Such a conductor track may be used in a component carrier to transport an electric signal in a specific manner (in a specific direction). A plurality of metal traces may be manufactured from on metal layer by separating the metal layer using etching.

In the context of the present document, the term "film" may in particular refer to any thin layer (e.g. a foil) that is suitable to cover (the surface of) a metal layer. In particular, the film may be patterned, thereby producing holes that expose parts of the covered metal layer. In an example, the film is configured to be patterned by photo-imaging, in particular photolithography. In a further example, the film comprises a resin material (and/or dielectric material) such as an organic material. In a preferred example, the film may comprise a photoresist (positive (e.g. DNQ-Novolac) or negative (e.g. epoxy-based polymer). The photoresist may be photopolymeric, photodecomposing, or photocrosslinking.

According to an exemplary embodiment, the invention may be based on the idea that a component carrier metal trace may be provided in an accurate and reliable manner, when a metal layer, covered by a patterned film, is subjected to (at least) two different etch steps to thereby separate the metal trace from the rest of the metal layer. Specifically, the patterned film exposes parts of the metal layer surface to the etching steps. The first etch step removes a part of the metal layer (and forms a small cavity) and maintains (part of) the film. The second etch step removes enough material from the metal layer so that a large cavity is formed, preferably said second etch does (essentially) not affect the film (i.e. a cavity that extends from top to bottom of the vertical thickness of the metal layer). In this manner, the first etch preferably affects the film (thickness reduction) and the metal layer, while the second etch only affects the metal layer. In other words, the metal layer may be partially etched in a first step and fully etched in a second step.

By using these measures, a fine line patterning (fine line-space ratio) between metal traces and a high etching factor per metal trace may be achieved (finer L/S with thinner copper thickness). This may hold in particular true, even if the metal layer is a thick (copper) layer, wherein the term "thick" may refer to a vertical thickness of 30 µm or more. Thus, in an exemplary embodiment, a line space ratio L/S of 35/45 µm is achieved, even though a 36 µm thick copper layer has been separated to form the metal traces.

While using the described process, it may be possible to create fine metal traces with high resolution with the use of etching techniques. One advantage may be to create smaller pitch sizes which supports the ongoing miniaturization progress.

### Exemplary Embodiments

According to an embodiment, forming the metal trace further comprises: i) forming a first cavity in the metal layer by the first etch and/or the second etch, and ii) forming a second cavity in the metal layer by the first etch and/or the second etch, so that the metal trace is located between the first cavity and a further (e.g. the second) cavity. In this manner, a plurality of metal traces may be formed efficiently side by side to each other.

According to a further embodiment, the area, where the first etch and the second etch are carried out comprises at least two adjacent sub-areas on one of the component carrier main surface, said at least two sub-areas being provided at a distance from each other to form the metal trace in between, in particular wherein the at least two adjacent sub-areas are defined by the patterning of the film.

According to a further embodiment, the first etch comprises a wet etch or a dry etch, in particular a plasma etch, more in particular a descum etch. In an example, the first etch is applied so that the metal layer and the film are affected. In a further example, the first etch may remove (significantly) less metal material than the second etch. While the first etch may consist of only one etching step, the second etch may also comprise two or more steps, for example a plasma etch and a descum etch. The first etch may further comprise the application of pressure.

The term "plasma etch" may refer to a process of processing a component carrier preform using a plasma. Plasma etching may comprise a high-speed stream of glow discharge (plasma) of an appropriate gas mixture being applied (in pulses) to the component carrier preform. The plasma, here the etch species, may be charged (ions) or neutral (atoms and radicals). During the etch process, the plasma may generate volatile etch products from the chemical reactions between the elements of the etched material and the reactive species generated by the plasma. The plasma etch may remove only film material (residues) or film material and metal material. The plasma may further improve the wettability of the copper.

In an example, during plasma etching, reactive species (neutral and charged) may be formed out of the used plasma gases. Neutral species have a longer lifetime and are weaker compared to charged species. During ion bombardment, mainly charged high reactive species are formed (CF³⁺, Ar⁺, etc.), which are accelerated inside an electric field and are focused on a target. Besides the chemical reaction, the high physical impact power may remove material, while hitting the surface.

In an exemplary example, the first etch comprises a plasma etch of plasma etch and electrolytic etch, which means
i) the first etch can only apply plasma etch under the condition of some gas mixture such as e.g. perfluorocarbons (CF4, C3Fs), or inorganic gases (SF₆, F₂, Cl₂, O₂, H₂) to etch the film and metal at the same time, or
ii) the first etch comprises the plasma to etch the film and an electrolytic etch to deplete the (copper) metal.

Regarding the electrolytic etch, the part of exposed metal may be dissolved in the chemical(s), when a cathode is in the bath, while the metal (copper) may be the anode. With this reaction, the exposed metal may be removed.

According to a further embodiment, the second etch comprises a wet etch or a dry etch. In an example, the second etch is applied so that the metal layer only is affected. In a further example, the second etch may remove (significantly) more metal material than the first etch. While the first etch may consist of only one etching step, the second etch may also comprise two or more steps, for example a two wet etches or, a wet etch and a dry etch.

The term "wet etch" may refer to an etching step in which a fluid (in particular a liquid) is applied. According to a specific example, etching may be done by using an etching solution from an etching bath. The etching solution may comprise copper (cupric) chloride (CuCl₂) and the etching reaction is as follows: CuCl₂ + Cu -> 2 CuCl (cuprous chloride). Hereby, copper chloride may be mixed with water and/or hydrochloric acid. Further, an additive such as HTB and/or an inhibitor (e.g. a polymer) may be used. In another example, iron (III) chloride may be used for etching as follows: Cu + 2 FeCl₃ -> CuCl₂ + 2 FeCl₂. In another example, copper nitrate and ammonium chloride may be used. In an embodiment, wet etching may be isotropic etching.

The term "dry etch" may refer to an etching step in which (essentially) no liquid is applied. Instead, an ion bombardment (e.g. a plasma of reactive gases such as oxygen or chlorine) may be applied to the component carrier preform. In an embodiment, dry etching may be anisotropic etching.

According to a further embodiment, the film is resistant to the second etch. This may provide the advantage that the film protects the main surface of the metal layer, while a deep hole (cavity) can be formed in the metal layer. Thereby, the metal trace may be manufactured more accurately.

According to a further embodiment, the film is not resistant to the first etch. This may provide the advantage that the film thickness (and film region around the opening of the cavity) is adapted to the cavity opening, so that an efficient second etch may be enabled. Also the residue of the film can be etched away, so the product will be manufactured in a reliable manner.

According to a further embodiment, the film is thinned during carrying out the first etch.

According to a further embodiment, the method further comprising: removing part of the film, and thereby enlarging the exposed area of the metal layer.

According to a further embodiment, the first etch and/or the second etch is an isotropic etch, in particular comprising an isotropic etchant, more in particular copper chloride. The term "isotropic etch" may refer to the circumstance that the amount of removed material is (essentially) similar in the z direction (thickness) of the metal layer and in the x/y plane (length and width) of the metal layer. Thereby, a more accurate etching may be achieved. Due to x/y/z-direction etching at the same time, the etching efficiency may be improved.

According to a further embodiment, patterning the film comprises: forming at least one hole in the film, so that sidewalls of the hole taper towards the metal layer. Tapering sidewalls may be formed by patterning in a specific manner. In another example, tapering sidewalls may be formed by etching. By providing tapering sidewalls, the second etch may be applied to the metal layer cavity more efficiently and accurately.

According to a further embodiment, forming the film comprises laminating (or coating, dispensing, spraying) the film onto the metal layer. Thereby, the film (e.g. an organic photoresist) may be attached/arranged on the metal layer in a robust manner using established technology.

According to a further embodiment, forming the film comprises: providing the film, before thinning, with a thickness of more than 12 µm, in particular more than 14 µm, more in particular more than 16 µm. A thicker film may be more robust and reliable during the patterning process.

According to a further embodiment, the first etch comprises thinning the film to a thickness of 90% or less, in particular 75% or less of the initial thickness (more in particular below 10 µm, in particular below 8 µm). A thinner film may be more feasible, when applying the second etch to the metal layer cavity.

According to a further embodiment, the film is a photoresist and/or a dry film (see above). While a wet film is coated onto a substrate in liquid form, a dry film may be (essentially) solvent-free. Thereby, a more efficient lamination may be achieved.

According to a further embodiment, the method further comprises: removing the film after the second etch. This measure may enable a further component carrier layer build-up on the metal layer.

According to a further embodiment, the metal layer has a vertical thickness (along the z-axis) of 30 µm or more, in particular 35 µm or more, in particular 40 µm or more, in particular 45 µm or more. Even though a thick metal layer is formed, a favorable line-space ratio may be achieved using the described method.

According to a further embodiment, the method further comprises forming a further metal trace next to the metal trace, so that the metal trace and the further metal trace are arranged side-by-side with a bottom-sided spacing (S) in between. Hence, a plurality of metal traces may be formed in one and the same process step.

According to a further embodiment, the area, where the first etch and the second etch are carried out, comprises more than two adjacent sub-areas on one of the component carrier main surfaces, wherein said more than two sub-areas are provided at a distance from each other, so that, after the first and the second etch, at least two adjacent metal traces between the sub-areas are formed side-by-side, in particular arranged with a bottom-sided spacing (S) in between.

In the following, embodiments are described which may provide especially advantageous line-space ratios and/or highly accurate etching factors. The term "line-space ratio" may refer to the width of the metal trace and the width of the resin trace, e.g. (30/40).

According to a further embodiment, (after the second etch) each of the metal trace and the further metal trace (the at least two adjacent metal traces) has a bottom-sided line width (L1) of 45 µm or less, in particular 40 µm or less, more in particular 35 µm or less, more in particular 30 µm or less, more in particular 25 µm or less. According to a further embodiment, (after the second etch) the metal trace and the further metal trace (the at least two adjacent metal traces) are spaced by the bottom-sided spacing (S) 45 µm or less, in particular 40 µm or less, more in particular 35 µm or less, more in particular 30 µm or less, more in particular 25 µm or less. In another example, the space is in the range 20 µm to 45 µm.

According to a further embodiment, (after the second etch) each of the metal trace and the further metal trace (the at least two adjacent metal traces) has a top-sided line width (L2) of at least 80%, in particular at least 90%, more in particular at least 100% (in particular in the range 80 to 100%) of its corresponding bottom-sided line width (L1).

According to a further embodiment, (after the second etch) each of the metal trace and the further metal trace (the at least two adjacent metal traces) has a vertical thickness (z) of 30 µm or more, in particular 35 µm or more, in particular 40 µm or more, in particular 45 µm or more.

According to a further embodiment, the etching factor of at least one metal trace (after etching) is 3 or larger, in particular is 5 or larger, in particular 7 or larger, in particular 10 or larger, in particular 15 or larger, in particular 20 or larger, in particular 25 or larger. This may provide the advantage that highly accurate component carriers can be produced using the described method.

In an embodiment, the component carrier comprises a stack of at least one electrically insulating layer structure and at least one electrically conductive layer structure. For example, the component carrier may be a laminate of the mentioned electrically insulating layer structure(s) and electrically conductive layer structure(s), in particular formed by applying mechanical pressure and/or thermal energy. The mentioned stack may provide a plate-shaped component carrier capable of providing a large mounting surface for further components and being nevertheless very thin and compact. The term "layer structure" may particularly denote a continuous layer, a patterned layer or a plurality of non-consecutive islands within a common plane.

In an embodiment, the component carrier is shaped as a plate. This contributes to the compact design, wherein the component carrier nevertheless provides a large basis for mounting components thereon. Furthermore, in particular a bare die as example for an embedded electronic component, can be conveniently embedded, thanks to its small thickness, into a thin plate such as a printed circuit board.

In an embodiment, the component carrier is configured as one of the group consisting of a printed circuit board, a substrate (in particular an IC substrate), and an interposer.

In the context of the present application, the term "printed circuit board" (PCB) may particularly denote a plate-shaped component carrier which is formed by laminating several electrically conductive layer structures with several electrically insulating layer structures, for instance by applying pressure and/or by the supply of thermal energy. As preferred materials for PCB technology, the electrically conductive layer structures are made of copper, whereas the electrically insulating layer structures may comprise resin and/or glass fibers, so-called prepreg or FR4 material. The various electrically conductive layer structures may be connected to one another in a desired way by forming holes through the laminate, for instance by laser drilling or mechanical drilling, and by partially or fully filling them with electrically conductive material (in particular copper), thereby forming vias or any other through-hole connections. The filled hole either connects the whole stack, (through-hole connections extending through several layers or the entire stack), or the filled hole connects at least two electrically conductive layers, called via. Similarly, optical interconnections can be formed through individual layers of the stack in order to receive an electro-optical circuit board (EOCB). Apart from one or more components which may be embedded in a printed circuit board, a printed circuit board is usually configured for accommodating one or more components on one or both opposing surfaces of the plate-shaped printed circuit board. They may be connected to the respective main surface by soldering. A dielectric part of a PCB may be composed of resin with reinforcing fibers (such as glass fibers).

In the context of the present application, the term "substrate" may particularly denote a small component carrier. A substrate may be a, in relation to a PCB, comparably small component carrier onto which one or more components may be mounted and that may act as a connection medium between one or more chip(s) and a further PCB. For instance, a substrate may have substantially the same size as a component (in particular an electronic component) to be mounted thereon (for instance in case of a Chip Scale Package (CSP)). More specifically, a substrate can be understood as a carrier for electrical connections or electrical networks as well as component carrier comparable to a printed circuit board (PCB), however with a considerably higher density of laterally and/or vertically arranged connections. Lateral connections are for example conductive paths, whereas vertical connections may be for example drill holes. These lateral and/or vertical connections are arranged within the substrate and can be used to provide electrical, thermal and/or mechanical connections of housed components or unhoused components (such as bare dies), particularly of IC chips, with a printed circuit board or intermediate printed circuit board. Thus, the term "substrate" also includes "IC substrates". A dielectric part of a substrate may be composed of resin with reinforcing particles (such as reinforcing spheres, in particular glass spheres).

The substrate or interposer may comprise or consist of at least a layer of glass, silicon (Si) and/or a photoimageable or dry-etchable organic material like epoxy-based build-up material (such as epoxy-based build-up film) or polymer compounds (which may or may not include photo- and/or thermosensitive molecules) like polyimide or polybenzoxazole.

In an embodiment, the at least one electrically insulating layer structure (and/or the base substrate) comprises at least one of the group consisting of a resin or a polymer, such as epoxy resin, cyanate ester resin, benzocyclobutene resin, bismaleimide-triazine resin, polyphenylene derivate (e.g. based on polyphenylenether, PPE), polyimide (PI), polyamide (PA), liquid crystal polymer (LCP), polytetrafluoroethylene (PTFE) and/or a combination thereof. Reinforcing structures such as webs, fibers, spheres or other kinds of filler particles, for example made of glass (multilayer glass) in order to form a composite, could be used as well. A semi-cured resin in combination with a reinforcing agent, e.g. fibers impregnated with the above-mentioned resins is called prepreg. These prepregs are often named after their properties e.g. FR4 or FR5, which describe their flame retardant properties. Although prepreg particularly FR4 are usually preferred for rigid PCBs, other materials, in particular epoxy-based build-up materials (such as build-up films) or photoimageable dielectric materials, may be used as well. For high frequency applications, high-frequency materials such as polytetrafluoroethylene, liquid crystal polymer and/or cyanate ester resins, may be preferred. Besides these polymers, low temperature cofired ceramics (LTCC) or other low, very low or ultra-low DK materials may be applied in the component carrier as electrically insulating structures.

In an embodiment, the at least one electrically conductive layer structure (and/or metal trace) comprises at least one of the group consisting of copper, aluminum, nickel, silver, gold, palladium, tungsten, titanium, and magnesium. Although copper is usually preferred, other materials or coated versions thereof are possible as well, in particular coated with supra-conductive material or conductive polymers, such as graphene or poly(3,4-ethylenedioxythiophene) (PEDOT), respectively.

At least one component may be embedded in the component carrier and/or may be surface mounted on the component carrier. Such a component can be selected from a group consisting of an electrically non-conductive inlay, an electrically conductive inlay (such as a metal inlay, preferably comprising copper or aluminum), a heat transfer unit (for example a heat pipe), a light guiding element (for example an optical waveguide or a light conductor connection), an electronic component, or combinations thereof. An inlay can be for instance a metal block, with or without an insulating material coating (IMS-inlay), which could be either embedded or surface mounted for the purpose of facilitating heat dissipation. Suitable materials are defined according to their thermal conductivity, which should be at least 2 W/mK. Such materials are often based, but not limited to metals, metal-oxides and/or ceramics as for instance copper, aluminium oxide (Al₂O₃) or aluminum nitride (AIN). In order to increase the heat exchange capacity, other geometries with increased surface area are frequently used as well. Furthermore, a component can be an active electronic component (having at least one p-n-junction implemented), a passive electronic component such as a resistor, an inductance, or capacitor, an electronic chip, a storage device (for instance a DRAM or another data memory), a filter, an integrated circuit (such as field-programmable gate array (FPGA), programmable array logic (PAL), generic array logic (GAL) and complex programmable logic devices (CPLDs)), a signal processing component, a power management component (such as a field-effect transistor (FET), metal-oxide-semiconductor field-effect transistor (MOSFET), complementary metal-oxide-semiconductor (CMOS), junction field-effect transistor (JFET), or insulated-gate field-effect transistor (IGFET), all based on semiconductor materials such as silicon carbide (SiC), gallium arsenide (GaAs), gallium nitride (GaN), gallium oxide (Ga₂O₃), indium gallium arsenide (InGaAs) and/or any other suitable inorganic compound), an optoelectronic interface element, a light emitting diode, a photocoupler, a voltage converter (for example a DC/DC converter or an AC/DC converter), a cryptographic component, a transmitter and/or receiver, an electromechanical transducer, a sensor, an actuator, a microelectromechanical system (MEMS), a microprocessor, a capacitor, a resistor, an inductance, a battery, a switch, a camera, an antenna, a logic chip, and an energy harvesting unit. However, other components may be embedded in the component carrier. For example, a magnetic element can be used as a component. Such a magnetic element may be a permanent magnetic element (such as a ferromagnetic element, an antiferromagnetic element, a multiferroic element or a ferrimagnetic element, for instance a ferrite core) or may be a paramagnetic element. However, the component may also be a IC substrate, an interposer or a further component carrier, for example in a board-in-board configuration. The component may be surface mounted on the component carrier and/or may be embedded in an interior thereof. Moreover, also other components, in particular those which generate and emit electromagnetic radiation and/or are sensitive with regard to electromagnetic radiation propagating from an environment, may be used as component.

In an embodiment, the component carrier is a build-up-type and/or laminate-type component carrier. In such an embodiment, the component carrier is a compound of multiple layer structures which are stacked and connected together by applying a pressing force and/or heat.

After processing interior layer structures of the component carrier, it is possible to cover (in particular by lamination) one or both opposing main surfaces (an (exposed) surface that is parallel to the directions of main extension (along x- and y-axes) of the component carrier) of the processed layer structures symmetrically or asymmetrically with one or more further electrically insulating layer structures and/or electrically conductive layer structures. In other words, a build-up may be continued until a desired number of layers is obtained.

After having completed formation of a stack of electrically insulating layer structures and electrically conductive layer structures, it is possible to proceed with a surface treatment of the obtained layers structures or component carrier.

In particular, an electrically insulating solder resist may be applied to one or both opposing main surfaces of the layer stack or component carrier in terms of surface treatment. For instance, it is possible to form such a solder resist on an entire main surface and to subsequently pattern the layer of solder resist so as to expose one or more electrically conductive surface portions which shall be used for electrically coupling the component carrier to an electronic periphery. The surface portions of the component carrier remaining covered with solder resist may be efficiently protected against oxidation or corrosion, in particular surface portions containing copper.

It is also possible to apply a surface finish selectively to exposed electrically conductive surface portions of the component carrier in terms of surface treatment. Such a surface finish may be an electrically conductive cover material on exposed electrically conductive layer structures (such as pads, conductive tracks, etc., in particular comprising or consisting of copper) on a surface of a component carrier. If such exposed electrically conductive layer structures are left unprotected, then the exposed electrically conductive component carrier material (in particular copper) might oxidize, making the component carrier less reliable.

A surface finish may then be formed for instance as an interface between a surface mounted component and the component carrier. The surface finish has the function to protect the exposed electrically conductive layer structures (in particular copper circuitry) and enable a joining process with one or more components, for instance by soldering. Examples for appropriate materials for a surface finish are Organic Solderability Preservative (OSP), Electroless Nickel Immersion Gold (ENIG), Electroless Nickel Immersion Palladium Immersion Gold (ENIPIG), gold (in particular hard gold), chemical tin, nickel-gold, nickel-palladium, etc.

### Brief Description of the Drawings

The aspects defined above, and further aspects of the invention are apparent from the examples of embodiment to be described hereinafter and are explained with reference to these examples of embodiment.
Figure 1 shows a component carrier according to an exemplary embodiment of the invention.
Figure 2 shows a method of manufacturing a component carrier according to an exemplary embodiment of the invention.
Figure 3 shows a method of manufacturing a component carrier according to another exemplary embodiment of the invention.
Figure 4 illustrates a definition of the etching factor.

### Detailed Description of the Drawings

The illustrations in the drawings are schematic. In different drawings, similar or identical elements are provided with the same reference signs.

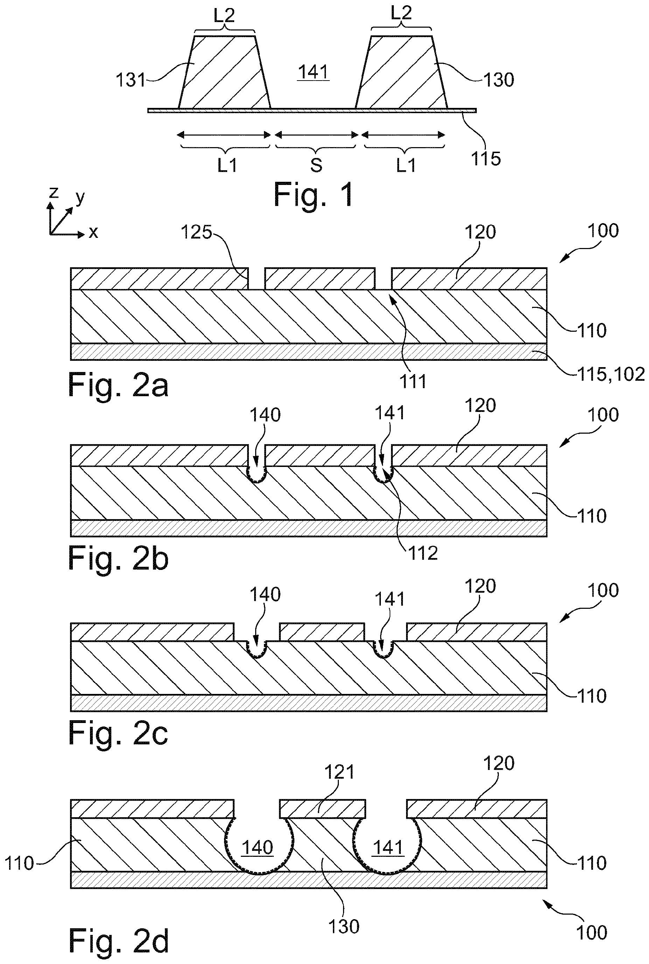

**Figure 1** shows a component carrier 100 according to an exemplary embodiment of the invention. The component carrier 100 comprises a stack (not shown in detail) having at least one electrically conductive layer structure 110 and at least one electrically insulating layer structure 102. The electrically insulating layer structure 102 is configured as a base substrate 115, e.g. of FR4 material. The electrically conductive layer structure 110 comprises e.g. a metal trace 130 and a further metal trace 131 arranged side by side with a bottom-sided spacing S in between. Each metal trace 130, 131 comprises a bottom-sided line width L1 and a top-sided line width L2. The bottom-sided line width L1 is for both metal traces 130, 131 less than 40 µm (in the example shown 35 µm). The bottom-sided spacing S is not more than 50 µm, in the example shown 40 µm. The top-sided line width L2 is for both metal traces 130, 131 in the range 80% to 100% of its corresponding bottom-sided line width L1, in the example shown 35 µm. Further, each of the metal traces 130, 131 has a vertical thickness (along the z-axis) of more than 30 µm, in the example shown 35 µm. It can be further calculated (see Figure 4) that the metal trace 130 and the further metal trace 131 respectively comprises an etching factor of more than 14.

**Figures 2a to 2d** show a method of manufacturing a component carrier 100 according to an exemplary embodiment of the invention.

Figure 2a: there is provided a metal layer 110, in this example a thick copper layer (e.g. 36 µm thickness) on an electrically insulating substrate 115, 102. An electrically insulating dry film 120, being a photoresist, is covered (laminated onto) the metal layer 110. Further, the film 120 is patterned (e.g. by photo lithography) in order to expose a part 111 of the metal layer 110. In other words, by forming exposed areas (with sidewalls 125) in the film 120, the part(s) of the metal layer 120 below the holes will be exposed.

Figure 2b: there is carried out a first etch which removes a further part 112 (which includes the part 111) of the exposed metal layer 110. By removing the further part(s) 112 of the metal layer 110, a cavity 140 and a further cavity 141 are formed in the metal layer 110.

Figure 2c: the first etch is a dry etch or wet etch (e.g. plasma etch, in particular a descum etch), to which the film 120 is not resistant. Thus, the first etch thins the film 120, removes part of the film 120 (and a further part 112 of the metal layer 110). In an example, the film 120 is thinned from a vertical thickness of more than 12 µm, in particular more than 14 µm to 10 µm or less, in particular 8 µm or less. As can be seen in Figure 2c, a part of the film 120, which covers a metal layer main surface at the tops of the cavity 140 and the further cavity 141, is also removed. Thereby, the upper main surface of the metal layer 110 is exposed around the openings of the cavity 140 and the further cavity 141.

Figure 2d: thereafter, it is carried out a second etch which enlarges the cavity 140 and the further cavity 141, so that a metal trace 130 is formed between the cavity 140 and the further cavity 141. Hereby, the entire metal plate thickness is removed in this area. In this manner, the formed metal trace 130 is spatially separated (by the cavity 140 and the further cavity 141) from the (rest of the) metal layer 110. The second etch comprises a wet etch (in particular using an isotropic etchant such as copper chloride) or a dry etch. Hereby, the film 120 is resistant to the second etch.

The metal trace 130 is still covered by a part of the film 121. The metal layer 110 is also still covered by the respective film parts 120. In a further step, however, the film 120, 121 can be removed (not shown).

**Figures 3a to 3c** show a method of manufacturing a component carrier 100 according to another exemplary embodiment of the invention. The method is very similar to the one described in Figures 2a to 2d above. The difference being that, during patterning of the film 120, sidewalls 125 of the holes in the film 120 are formed such that the film sidewalls 125 taper, with respect to the cavity 140 and the further cavity 141, towards the cavity 140 and the further cavity 141 (and to the metal layer 110). The angles of the sidewalls 125 with respect to the upper main surface of the metal layer 110 are preferably in the range 20 to 70°, more preferably around 60°.

Figure 3a: during patterning of the film 120, holes are formed in the film 120 and the sidewalls 125 of the holes taper with respect to the cavity 140 and the further cavity 141. During the first etch, the cavity 140 and the further cavity 141 are formed.

Figure 3b: further, during the first etch, the film 120 is thinned (a part 122 in the vertical thickness is removed). This takes also place at the tapering sidewalls 125.

Figure 3c: there is performed the second etch which enlarges the cavity 140 and the further cavity 141, so that a metal trace 130 is formed between the cavity 140 and the further cavity 141. The film 120 is resistant to the second etch, so that the respective tops of the cavity 140 and the further cavity 141 are partially covered by the film 120 (and the tapering sidewalls 125).

**Figure 4** illustrates the definition of the etching factor (EF) that can be used to validate the quality of a (etched) metal trace. After etching a metal layer, an etched (trapezoidal) metal trace 130 can be described by the etching factor EF as follows: two times the line thickness (Thk, height) divided by the line width top (TW or L2) subtracted from the line width bottom (BW or L1): EF = (2^{∗}Thk) / (BW - TW). For example, an etching factor of three or more, in particular five or more, may be considered as accurate, depending on the manufacture circumstances.

It should be noted that the term "comprising" does not exclude other elements or steps and the "a" or "an" does not exclude a plurality. Also elements described in association with different embodiments may be combined. It should also be noted that reference signs in the claims shall not be construed as limiting the scope of the claims. Implementation of the invention is not limited to the preferred embodiments shown in the figures and described above. Instead, a multiplicity of variants are possible which use the solutions shown and the principle according to the patent even in the case of fundamentally different embodiments.

### Reference signs

- 100: Component carrier
- 110: Metal layer
- 111: Area of metal layer
- 112: Part of metal layer
- 115: Substrate, electrically insulating layer structure
- 120: Film, film part
- 121: Further film part
- 122: Removed film part
- 130: Metal trace
- 131: Further metal trace
- 140: First cavity
- 141: Second/further cavity

- L1: Bottom-sided line width
- L2: Top-sided line width
- S: Bottom-sided spacing

## Claims

1. A method of manufacturing a component carrier (100), wherein the method comprises:
providing a metal layer (110), in particular a copper layer;
providing a film (120) on the metal layer (110);
patterning the film (120) in order to expose an area (111) of the metal layer (110);
carrying out a first etch, thereby removing a part (112) of the exposed metal layer (110) and maintaining a thickness of the film (120); and thereafter
carrying out a second etch, thereby forming at least one metal trace (130) that is spatially separated from the metal layer (110).

2. The method according to claim 1, wherein forming the metal trace (130) further comprises:
forming a first cavity (140) in the metal layer (110) by the first etch and the second etch, and
forming a further cavity (141) in the metal layer (110) by the first etch and the second etch,
so that the metal trace (110) is located between the first cavity (140) and the further cavity (141).

3. The method according to claim 1 or 2,
wherein the area, where the first etch and the second etch are carried out, comprises at least two adjacent sub-areas (140, 141) on one of the component carrier main surfaces, wherein said at least two sub-areas (140, 141) are provided at a distance from each other to form the metal trace (130) in between,
in particular wherein the at least two adjacent sub-areas (104, 141) are defined by the patterning of the film (120).

4. The method according to any one of the preceding claims,
wherein the first etch comprises a wet etch or a dry etch, in particular a plasma etch, more in particular a descum etch.

5. The method according to any one of the preceding claims,
wherein the second etch comprises a wet etch or a dry etch.

6. The method according to any one of the preceding claims,
wherein the film (120) is resistant to the second etch; and/or
wherein the film (120) is not resistant to the first etch.

7. The method according to any one of the preceding claims,
wherein the film (120) is thinned during carrying out the first etch, in particular wherein the method further comprises:
removing part of the film (120), and thereby
enlarging the exposed area (111) of the metal layer (110).

8. The method according to any one of the preceding claims,
wherein the first etch and/or the second etch is an isotropic etch, in particular comprising an isotropic etchant, more in particular copper chloride.

9. The method according to any one of the preceding claims, wherein patterning the film (120) comprises:
forming at least one exposed area in the film (120), wherein the sidewalls (125) of the at least one exposed area taper towards the metal layer (110).

10. The method according to any one of the preceding claims, wherein forming the film (120) comprises:
laminating the film (120) onto the metal layer (110).

11. The method according to any one of the preceding claims, further comprising at least one of the following features:
wherein forming the film (120) comprises:
providing the film (120), in particular before thinning, with a thickness of 12 µm or more, in particular 14 µm or more;
wherein maintaining the thickness comprises:
thinning the film (120), in particular to a thickness of 90% or lower, in particular 75% or lower, of the initial thickness;
wherein the film (120) is a dry film or a wet film;
wherein the method further comprises:
removing the film (120) after the second etch;
wherein the metal layer (110) has a thickness (z) of 30 µm or more, in particular 35 µm or more.

12. The method according to any one of the preceding claims, further comprising:
forming a further metal trace (131) next to the metal trace (130), so that the metal trace (130) and the further metal trace (131) are arranged side-by-side with a bottom-sided spacing (S) in between.

13. The method according to claim 12, further comprising at least one of the following features:
wherein the area, where the first etch and the second etch are carried out, comprises more than two adjacent sub-areas (140, 141) on one of the component carrier main surfaces, wherein said more than two sub-areas (140, 141) are provided at a distance from each other, so that, after the first and the second etch, at least two adjacent metal traces (130, 131) between the sub-areas (140, 141) are formed side-by-side,
in particular, wherein the sub-areas (140, 141) are arranged with a bottom-sided spacing (S) in between;
wherein, after the second etch, each of the at least two metal traces (130, 131) has a bottom-sided line width (L1) of 40 µm or less;
wherein, after the second etch, at least two adjacent metal traces (130, 131) are spaced by the bottom-sided spacing (S) of less than 45 µm, in particular in the range 30 µm to 45 µm;
wherein, after the second etch, each of the at least two adjacent metal traces (130, 131) has a top-sided line width (L2) in the range 80% to 100% of its corresponding bottom-sided line width (L1);
wherein, after the second etch, each of the adjacent metal traces (130, 131) has a thickness (z) of at least 30 µm, in particular in the range 30 µm to 50 µm.

14. A component carrier (100) which comprises a stack having at least one electrically conductive layer structure (110) and at least one electrically insulating layer structure (102);
wherein the at least one electrically conductive layer structure (110) comprises a metal trace (130) and a further metal trace (131) arranged side by side;
wherein each of the metal trace (130) and the further metal trace (131) has a bottom-sided line width (L1) of 40 µm or less;
wherein the metal trace (130) and the further metal trace (131) are spaced by a bottom-sided spacing (S) of 45 µm or less;
wherein each of the metal trace (130) and the further metal trace (131) has a top-sided line width (L2) of at least 80% of its respective bottom-sided line width (L1); and
wherein each of the metal trace (130) and the further metal trace (131) has a vertical thickness (z) of 30 µm or more.

15. The component carrier (100) according to claim 14,
wherein the metal trace (130) and/or the further metal trace (131) comprises an etching factor of 3 or more, in particular 5 or more.
